# EUROPÄISCHE PATENTSCHRIFT

(11) **EP 0 538 502 B1**
(45) Veröffentlichungstag und Bekanntmachung des Hinweises auf die Patenterteilung: **02.07.1997**
(21) Anmeldenummer: 91117888.7
(22) Anmeldetag: 19.10.1991
(51) Int. Cl.: H03K 17/97, H01H 3/02, H03K 17/96

(54) **Befehlsgerät mit sicherer Rückstellfunktion**
Control device with a safe reset function
Appareil de commande comprenant une remise à zéro de sécurité

(43) Veröffentlichungstag der Anmeldung: 28.04.1993
(73) Patentinhaber: Both, Helmut, Dipl.-Ing., D-55278 Ludwigshöhe (DE)
(72) Erfinder: Both, Helmut, Dipl.-Ing., D-55278 Ludwigshöhe (DE)
(74) Vertreter: Quermann, Helmut, Dipl.-Ing.

(56) Entgegenhaltungen:
- WO-A-90/13822
- CH-A- 0 422 980
- DE-B- 1 146 551
- US-A- 3 657 685

## Beschreibung

Die Erfindung betrifft ein Befehlsgerät gemäß dem Oberbegriff des Patentanspruches 1.

Für Steuerungsvorgänge an Maschinen und Anlagen, sowie handgeführten, kraftbetriebenen Werkzeugen und anderen technischen Arbeitsmitteln werden zur Ausführung bestimmter Betriebsfunktionen Befehlsgeräte eingesetzt, die einen, von einer Person eingeleiteten Eingangsbefehl nur so lange in einen Ausgangsbefehl umwandeln, wie der Eingangsbefehl bestehen bleibt, das heißt ein einmal eingeleiteter Eingangsbefehl wird nicht gespeichert. Es wird daher entsprechend der bestimmungsgemäßen Wirkungsweise solcher Befehlsgeräte davon ausgegangen, daß der erzeugte Ausgangsbefehl nur so lange bestehen bleibt, wie die Betätigung erfolgt und nach beendeter Betätigung, zum Beispiel durch Loslassen wieder verschwindet.

Befehlsgeräte dieser Art sind in der Steuerungstechnik unter der Bezeichnung "Tippschaltung" oder "Tippschalter" bekannt. Versagt ein solcher Tippschalter in der Art, daß er nach Beendigung seiner Betätigung das von ihm erzeugte Ausgangssignal nicht selbstätig löscht und dieses weiterhin erzeugt, so kann das bei gefährlichen oder potentiell gefährlichen Arbeitsvorgängen, die gerade wegen ihrer Gefährlichkeit über Tippschalter gesteuert werden, zu Schäden an Personen und Sachen führen. Gründe für das Versagen können zum Beispiel sein, das einfache Verklemmen beweglicher Teile, Bruch, der üblicherweise für die selbstätige Rückstellung vorgesehenen Feder(n), Verschweißen von Kontakten usw..

Aus der WO-A-90 013 822 ist ein Befehlsgerät der eingangs genannten Art bekannt. Dort ist der Hilfskörper als über Lagerelemente positionierter Stößel ausgebildet und bildet Bestandteil des Stellteiles. Das Stellteil wird durch den Antrieb in eine oszillierende Bewegung versetzt, und diese durch das Stellteil zum Sensor fortgeleitet und von diesem erkannt. Eine Einleitung eines Eingangsbefehles dämpft die oszillierende Bewegung des Stellteiles. Das Stellteil weist einen Drucktaster und eine mit diesem verbundene, den Stößel bildende Tasterstange auf, wobei mit dieser antriebsseitig ein Anker oder ein Elektromagnet und sensorseitig ein Dauermagnet oder ein Elektromagnet verbunden ist.

Aufgabe der Erfindung ist es, ein Befehlsgerät der genannten Art so weiter zu bilden, daß nach Beendigung der Betätigung des Stellteiles oder beim Auftreten von Fehlern im Befehlsgerät ein durch Betätigung erzeugtes Ausgangssignal bei Beendigung der Betätigung selbstätig und sicher unterbrochen bzw. beendet wird.

Gelöst wird die Aufgabe durch ein Befehlsgerät mit den Merkmalen des Patentanspruches 1. Die erfindungsgemäße Ausbildung des Befehlsgerätes stellt zunächst sicher, daß der Hilfskörper nur dann von seiner Blockierung frei kommt, wenn das Stellteil betätigt ist. Nur in freigekommenem Zustand kann der über die federnden Elemente bzw. Magnete positionierte Hilfskörper mittels des Antriebes in eine Bewegung versetzt werden und nur in diesem Betriebszustand der Sensor das Ausgangssignal an das Steuersystem weiterleiten. Wird die Betätigung des Stellteiles beendet, bedingen die federnden Elemente bzw. Magnete , daß der Hilfskörper wieder blockiert wird, womit der Sensor keine Bewegung des Hilfskörpers mehr erfassen und demzufolge kein Ausgangssignal mehr an das Steuersystem weiterleiten kann. Sollten Fehler im Befehlsgerät auftreten, beispielsweise im Bereich eines der federnden Elemente oder Magnete, so bewirken die verbleibenden federnden Elemente oder Magnete, daß der Hilfskörper dennoch in die blockierte Stellung überführt wird und gleichermaßen kein Ausgangssignal mehr erzeugt wird. Grundprinzip der vorliegenden Erfindung ist, daß bei einer Beendigung der Betätigung des Stellteiles bzw. bei einem Fehler im Befehlsgerät, der ein Beenden des Ausgangssignals nach Beendigung des Eingangsbefehls verhindern würde, der Hilfskörper eine Blockierung erfährt, so daß über den Sensor kein Ausgangssignal an das Steuersystem weitergeleitet werden kann. Der Antrieb zum Bewegen des Hilfskörpers kann dauernd im Betrieb sein oder auch nur dann in Betrieb gesetzt werden, wenn der Hilfskörper von der Blockierung freigekommen ist. Im ersten Fall ist die vom Antrieb in den Hilfskörper zu dessen Bewegung bei betätigtem Stellteil einleitbare Kraft so zu bemessen, daß diese nicht ausreichend ist, um den Hilfskörper bei nicht betätigtem Stellteil von der Blockierung freikommen zu lassen. Im letztgenannten Fall kann die Ansteuerung des Antriebes über den Sensor erfolgen, der bei einer Betätigung des Stellteiles und damit einem Freikommen des Hilfskörpers von der Blockierung dessen Bewegung erfaßt und ein Signal zum Inbetriebsetzen des Antriebes an diesen abgibt. Bei Beendigung der Betätigung des Stellteiles wird der Hilfskörper wieder blockiert, womit die Ansteuerung des Antriebes über den Sensor entfällt und der Antrieb damit abgeschaltet wird.

Gemäß einer ersten bevorzugten Ausführungsform der Erfindung ist vorgesehen, daß der Hilfskörper mittels Federn zwischen dem Stellteil und einem stationären Bauteil des Befehlsgerätes aufgehängt ist. Zweckmäßig sollte der Hilfskörper als Hohlzylinder ausgebildet sein, den das Stellteil in dessen Längsachse durchsetzt, wobei innere Federn im Bereich beider Hohlzylinderenden an diesem und an dem Stellteil angreifen, sowie äußere Federn im Bereich beider Hohlzylinderenden an diesem und dem stationären Bauteil. Die äußeren Federn sollten bei nicht betätigtem Stellteil den Hilfskörper gegen die Blockierung vorspannen, wobei diese zweckmäßig als stationärer Anschlag ausgebildet ist. Es wird in diesem Zusammenhang als vorteilhaft angesehen, wenn der Anschlag auf der dem Betätigungspunkt des Stellteils zugewandten Ende des Hohlyzlinders in dessen Bewegungsweg ragt. Die Federn können sowohl als Zugfedern, wobei hier insbesondere an Spiral-Zugfedern gedacht ist, als auch als Druckfedern, wobei hier insbesondere als Spiral-Druckfedern gedacht ist, ausgebildet sein.

Bei der zuvor beschriebenen Lagerung des Hilfskörpers ausschließlich über Federn am Stellteil und am stationären Bauteil des Befehlsgerätes ziehen bei einer Ausbildung der Federn als Zugfedern bzw. Drücken bei einer Ausbildung als Druckfedern die Federn bei einer Betätigung des Stellteiles den Hilfskörper vom diesem zugeordneten Anschlag weg, so daß der Hilfskörper ausschließlich von den Federn gehalten wird. So können beispielsweise benachbart dem jeweiligen Hohlzylinderende drei sternförmig oder vier jeweils um 90° zueinander versetzt angeordnete innere sowie drei sternförmige oder entsprechend vier jeweils um 90° zueinander versetzt angeordnete äußere Federn vorgesehen sein. Aufgrund der Vorspannung der äußeren Federn würden diese beim Loslassen des Stellteiles den Hilfskörper wieder gegen die Blockierung ziehen.

Bei von der Blockierung freigekommenem Hilfskörper wird dieser, wie zuvor bereits beschrieben, durch einen Antrieb in eine Bewegung versetzt, die vom Sensor erfaßt und als Ausgangssignal an das Steuersystem weitergeleitet wird. Der Antrieb ist vorteilhaft als magnetisches System ausgebildet, das insbesondere aus einem Elektromagneten und dem Hilfskörper besteht. Der Sensor ist vorteilhaft gleichfalls als elektromagnetisches System ausgebildet, das bevorzugt aus einem Elektromagneten und dem Hilfskörper besteht. Die Erfindung ist aber nicht darauf beschränkt, daß Antrieb und Sensor als elektromagnetisches System ausgebildet sind, es sind beispielsweise auch pneumatisch piezoelektrische Systeme oder Kombinationen hiervon denkbar. Bei einer Lagerung des Hilfskörpers über federnde Elemente wird dem Hilfskörper mittels des Antriebes bevorzugt eine translatorisch oszillierende Bewegung aufgegeben, es ist aber auch eine rotatorisch oszillierende Bewegung oder eine Überlagerung der genannten Bewegungen denkbar.

Eine zweite bevorzugte Ausführungsform der Erfindung sieht vor, daß der Hilfskörper mittels an diesem, am Stellteil und am stationären Bauteil des Befehlsgerätes angeordneter Magnete zwischen dem Stellteil und dem stationären Bauteil positioniert ist. Zweckmäßig ist dabei der Hilfskörper als Hohlzylinder ausgebildet, den das Stellteil in dessen Längsachse durchsetzt, wobei innere Magnete mit dem Stellteil, mittlere Magnete mit dem Hohlzylinder und äußere Magnete mit dem stationären Bauteil verbunden sind, wobei ferner die inneren und mittleren bzw. mittleren und äußeren Magnete in den einander zugewandten Wirkbereichen gleiche Polarität aufweisen und bei nicht betätigtem Stellteil dieses in derselben Wirkrichtung wie der Hohlzylinder blockiert ist. In diesem Zusammenhang sollten die mittleren Magnete im Bereich der Hohlzylinderenden angeordnet sein, in gleichem Abstand wie die mittleren Magnete die inneren Magnete bzw. die äußeren Magnete zueinander beabstandet angeordnet sein, und die als stationäre Anschläge ausgebildeten Blockierungen für das Stellteil und den Hohlzylinder sowie auch die äußeren Magnete so positioniert sein, daß bei Anlage an den Anschlägen die dem jeweiligen Ende des Hohlzylinders zugeordneten Magnete vom inneren Magnet zum äußeren Magnet zueinander versetzt angeordnet sind und dabei vom einem inneren Magneten zugeordneten Anschlag weggerichtet sind.

Die Magnete sind bevorzugt als Permanentmagnete ausgebildet und besitzen die gleiche Wirkungsweise wie schräggestellte Druckfedern, das heißt sie könnten durch derartige Druckfedern ersetzt werden. Beim Betätigen des Stellgliedes verschieben die inneren Magnete wegen deren abstoßenden Wirkung bezüglich der äußeren Magnete diese und damit den Hilfskörper, womit er von der Blockierung freikommt und in seiner Bewegungsfähigkeit nicht mehr beeinträchtigt wird, so daß mittels des Antriebes auf den Hilfskörper eine Bewegung aufgebracht werden kann. Diese Bewegung kann nicht nur, wie bei der Verwendung von Federn translatorisch oszillierend, rotatorisch oszillierend oder eine Überlagerung hiervon sein, sondern auch rotatorisch nicht oszillierend, somit eine reine Drehbewegung in unveränderlicher Drehrichtung darstellen. Antrieb und Sensor sind dabei wie vorbeschrieben ausgebildet.

Vorteilhaft ist die Stellbewegung des Stellteiles in Betätigungsrichtung durch einen Anschlag begrenzt. Dieser Anschlag kann bei dem erfindungsgemäßen Befehlsgerät zur Darstellung einer zweiten Position bzw. einer dritten Position des Stellteiles Verwendung finden. Bei einer ersten Variante, die grundsätzlich Verwendung finden kann, ergibt sich eine erste Position des Stellteiles, wenn dieses nicht betätigt ist, und eine zweite Position, wenn es betätigt ist und der Hilfskörper von seiner Blockierung freigekommen ist, bei dieser zweiten Position liegt das Stellteil am die Stellbewegung des Stellteils begrenzenden Anschlag an. Bei einer zweiten Variante, die bei der Ausbildung des Befehlsgerätes mit Druckfedern bzw. Magneten Verwendung finden kann, stellt sich eine erste Position des Stellteils dar, wenn es nicht betätigt ist, eine zweite Position, ohne daß das Stellteil an einen Anschlag gelangt, wenn es betätigt ist und der Hilfskörper von der Blockierung freigekommen ist, schließlich eine dritte Position bei Anlage am Anschlag, wenn das Stellteil voll aus der Ausgangslage herausbewegt ist, aber dennoch kein Ausgangssignal auftritt, weil der Hilfskörper wieder blockiert ist. Die letztgenannte Variante ist von Bedeutung bei einer sogenannten Not-Aus-Schaltung, bei der die das Stellteil bedienende Person im Panikfall, statt das Stellteil loszulassen, dieses mit einer noch größeren Kraft beaufschlagt und weiter verschiebt. Bei einer Verwendung von Druckfedern führt dies dazu, daß die Federn überschnappen, bei einer Verwendung von Magneten, daß die inneren Magnete sich den mittleren Magneten bis zu einem minimalen Abstand nähern und in gleicher Bewegungsrichtung beim vollständigen Durchdrücken des Stellteiles von diesen wegbewegt werden, so daß die mittleren Magnete durch die abstoßende Wirkung zu den inneren Magneten und auch zu den äußeren Magneten von diesen in entgegengesetzter Bewegungsrichtung gegen die Blockierung bewegt werden. Im Ergebnis ergibt sich bei Anlage des Stellteiles an dem dessen Stellbewegung in Betätigungsrichtung begrenzenden Anschlag eine Not-Aus-Einrastung, die das Signal speichert, das heißt es ist die Not-Aus-Betätigung des Stellteiles so lange von außen sichtbar, wie das Stellteil nicht aktiv von dem Anschlag weggezogen wird.
Die Erfindung ist nicht darauf beschränkt, daß das Stellteil, bzw. eine Bestandteil des Stellteils bildende Taste gedrückt wird, sondern es kann das Stellteil durchaus auch durch Ziehen betätigt werden. Gedacht ist dabei beispielsweise an mit dem Stellteil verbundene Reißleinen, wobei sichergestellt sein soll, daß bei einem Reißen der Reißleine ein Ausgangssignal an das Steuersystem weitergeleitet wird. In diesem Fall ist eine umgekehrte Anordnung der zuvor beschriebenen Bauteile des erfindungsgemäßen Befehlsgerätes vorzunehmen.

Weitere Merkmale der Erfindung sind in den Unteransprüchen und der Beschreibung der Figuren dargestellt, wobei bemerkt wird, daß alle Einzelmerkmale und alle Kombinationen von Einzelmerkmalen erfindungswesentlich sind.

In den Figuren ist die Erfindung an zwei Ausführungsformen beispielsweise dargestellt, ohne auf diese beschränkt zu sein. Es zeigt:
- Figur 1: eine schematische Darstellung der Ausbildung und Anordnung der wesentlichen Merkmale einer ersten Ausführungsform des erfindungsgemäßen Befehlsgerätes unter Verwendung von Federn, gezeigt in einem Mittellängsschnitt bei unbetätigtem Befehlsgerät,
- Figur 2: eine Darstellung gemäß Figur 1 bei betätigtem Befehlsgerät,
- Figur 3: eine schematische Darstellung der Ausbildung und Anordnung der wesentlichen Merkmale einer zweiten Ausführungsform des erfindungsgemäßen Befehlsgerätes unter Verwendung von Magneten, gezeigt in einem Mittellängsschnitt bei unbetätigtem Befehlsgerät,
- Figur 4: eine Darstellung gemäß Figur 3 bei betätigtem Befehlsgerät und
- Figur 5: eine Darstellung des in den Figuren 3 und 4 gezeigten Befehlsgerätes mit in dritter Position befindlichem, gegen einen Anschlag betätigtem Stellteil.

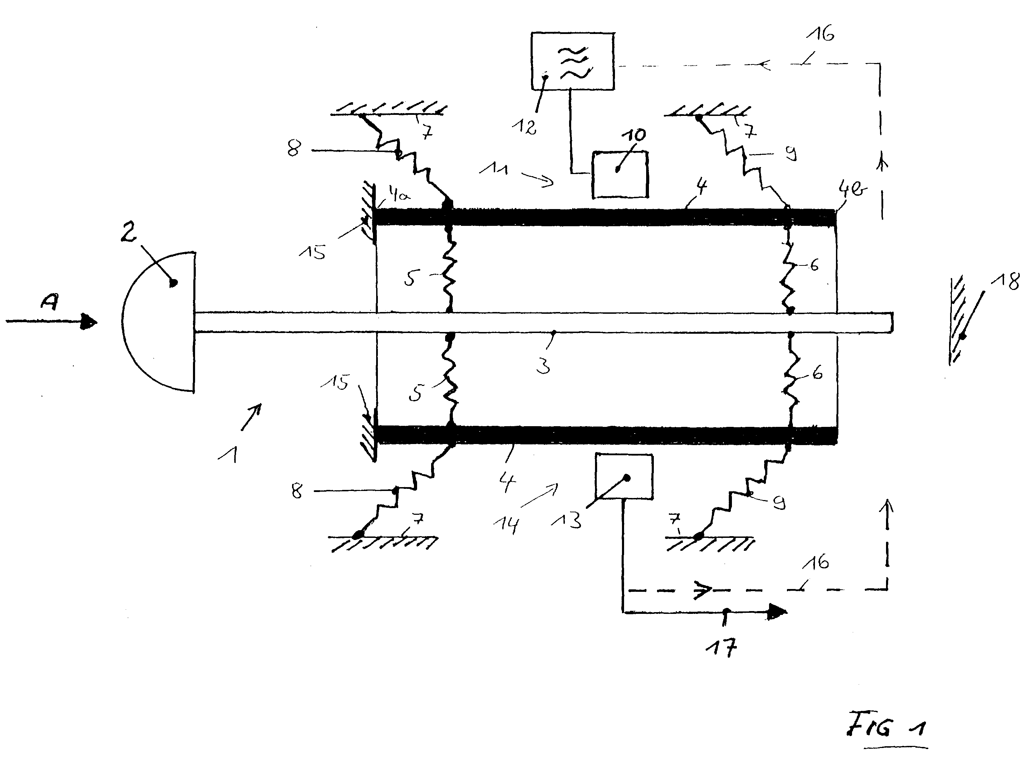

Figur 1 zeigt ein Stellteil 1, das aus einem Drucktaster 2 und einem fest mit diesem verbundenen inneren stabförmigen Stößel 3 besteht. Den Stößel umgibt ein Hohlzylinder 4, der als längliche Hülse ausgebildet ist. Die Länge des Hohlzylinders 4 entspricht etwa zweidrittel der Länge des Stößels 3, der Hohlzylinder 4 ist im drucktasterfernen Bereich rotationssymmetrisch zum Stößel 3 positioniert. Beabstandet zueinander angeordnete Zug-Spiralfedern 5 und 6 greifen einerseits außen am Hohlzylinder 4, andererseits innen am Stößel 3 in geringfügig zu den beiden Hohlzylinderenden 4a und 4b beabstandeten Ebenen an. In der einen Ebene sind vier in einem Winkel von jeweils 90° zueinander versetzt angeordnete Federn 5 und in der anderen Ebene entsprechend vier um einen Winkel von 90° zueinander versetzt angeordnete Federn 6 angeordnet; in der Zeichnung der Figur 1 sind pro Ebene jeweils nur zwei Federn 5 bzw. 6 gezeigt. Bei nicht betätigtem Stellteil 1 ist die Wirkrichtung der Federn 5 und 6 radial.

Der Hohlzylinder 4 durchsetzt das bezüglich des Stellteiles 1 und des Hohlzylinders 4 stationäre Gehäuse des Befehlsgerätes, von dem nur Ausschnitte der rotationssymmetrisch zum Hohlzylinder 4 angeordneten Gehäusewandung 7 gezeigt sind. In der radial äußeren Verlängerung der äußeren Angriffspunkte der Federn 5 und 6 am Hohlzylinder 4 greifen Zug-Spiralfedern 8 und 9 mit ihren inneren Enden außen am Hohlzylinder 4 an, sowie mit ihren äußeren Enden an der Gehäusewandung 7. Bei nicht betätigtem Stellteil 1 verläuft die Wirkrichtung der Federn 8 und 9 unter einem Winkel von etwa 45° zum Stößel 3 und dem Hohlzylinder 4, mit einer Zugkomponente auf den Hohlzylinder 4 in Richtung des Drucktasters 2. Aufgrund dieser Zugkomponente liegt der Hohlkörper 4 mit seinem Kreisringende 4a an einem Kreisringanschlag 15 an. In der Figur 1 sind nur jeweils zwei der vier jeweils um einen Winkel von 90° zueinander versetzten Federn 8 bzw. 9 gezeigt.

Zwischen den Federn 8 und 9 ist beabstandet zum Hohlkörper 4 ein stationärer Elektromagnet 10 angeordnet, dieser und der an dieser Stelle ferromagnetisch ausgebildete Hohlzylinder 4 stellen dessen Antrieb 11 dar. Über einen Oszillator 12 kann der Elektromagnet 10 gespeißt werden. Auf der dem Magneten 10 gegenüberliegenden Seite des Hohlzylinders 4 ist beabstandet zu dessen Außenseite ein weiterer stationärer Elektromagnet 13 angeordnet, der zusammen mit dem an dieser Stelle gleichfalls ferromagnetisch ausgebildeten Hohlzylinder 4 einen Sensor 14 bildet.

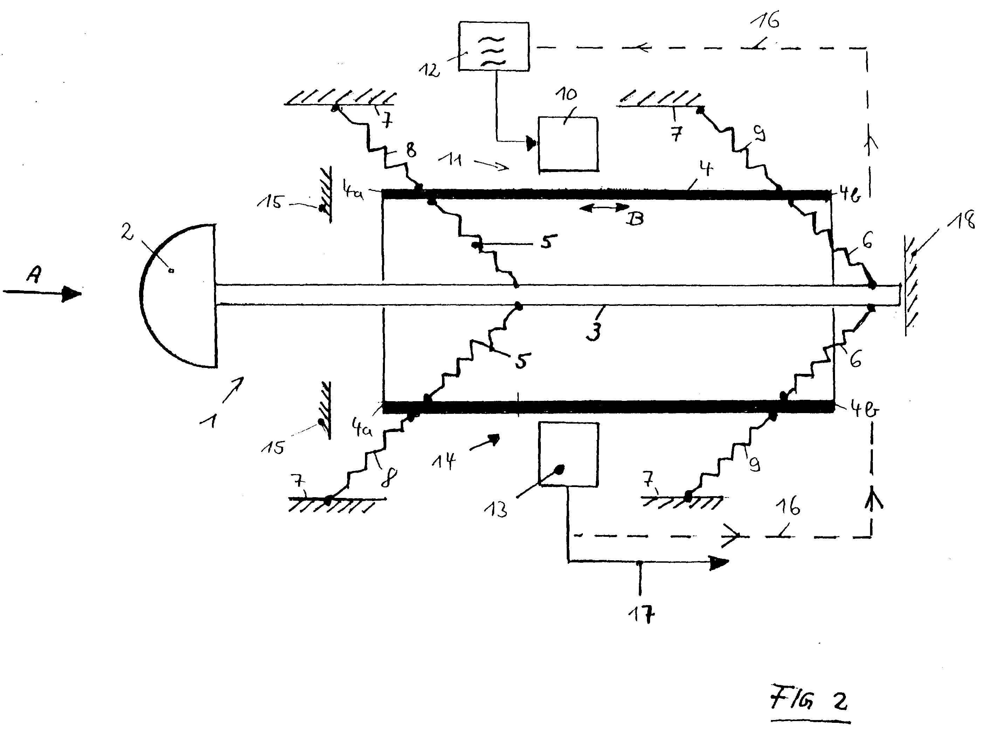

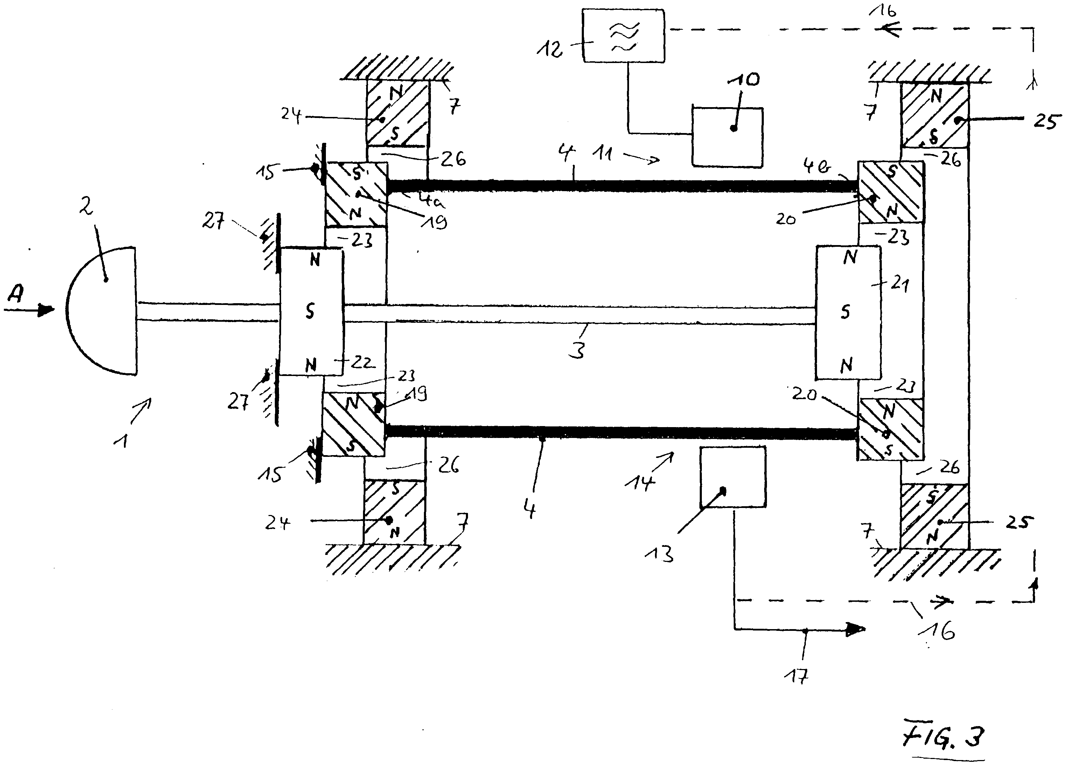

Beim Betätigen des Stellteiles 1 durch Drücken des Drucktasters 2 in Richtung des Pfeiles A - wie in Figur 2 verdeutlicht - ziehen die innerhalb des Hohlzylinders 4 angeordneten Federn 5 und 6 den Hohlzylinder 4 entgegen der Kraft der außerhalb des Hohlzylinders 4 angeordneten Federn 8 und 9 vom Anschlag 15 weg. Diese Anfangsbewegung wird vom Sensor 14 erkannt und als Sensorsignal 16 an den Oszillator 12 abgegeben, der aufgrund dieses Signales den Elektromagneten 10 so ansteuert, daß dieser aufgrund dessen Orientierung eine Kraft in Längsrichtung des Hohlzylinders 4 auf diesen aufbringt, womit der Hohlzylinder 4 in die translatorisch oszillierende Bewegung B versetzt wird, ohne an den Anschlag 15 anzustoßen. Die oszillierende Bewegung des Hohlzylinders 4 wird wiederum vom Sensor 14 erkannt und als weiteres Sensorsignal 17 an ein nicht gezeigtes nachgeschaltetes Steuersystem einer Maschine oder Anlage abgegeben. Zweckmäßig erfolgt zuvor eine Diskriminierung des Sensorsignals 17 in einem Amplitudendiskriminator, so daß das Sensorsignal 17 als binäres Ausgangssignal abgegeben wird. Wie ferner in Figur 2 gezeigt, ist im Bereich des drucktasterfernen Endes des Stellteiles 1 ein weiterer Anschlag 18 vorgesehen. Dieser ist so angeordnet, daß eine Überdehnung der Federn 5, 6, 8 und 9 ausgeschlossen ist, aber dennoch sichergestellt ist, daß bei Anlage des Stellgliedes 1 am Anschlag 18 der Hohlzylinder 4 über dessen gesamte Schwingungsamplitude hinreichend weit vom gegenüberliegenden Anschlag 15 entfernt ist und damit bei Beaufschlagung durch den Antrieb 11 frei schwingen kann.

Nach dem Loslassen des Drucktasters 2 ziehen die äußeren Federn 8 und 9 den Hohlzylinder 4 wieder in dessen blockierte Stellung gegen den Anschlag 15 zurück, der Sensor 14 kann damit keine Bewegung des Hohlzylinders 4 mehr erfassen und es wird demzufolge kein Sensorsignal 17 mehr an das Steuersystem abgegeben. Entsprechendes gilt, falls wesentliche Bauteile des Befehlsgerätes ausfallen sollten, derartiges führt entweder zu einer Bewegung des Hohlzylinders 4 gegen den zugeordneten Anschlag 15 oder einer Schrägstellung und damit einem Verklemmen des Hohlzylinders 5 im Gehäuse des Befehlsgerätes, und zu dessen Blockierung, womit dann keine Bewegung des Hohlzylinders 4 mehr vom Sensor 14 erfaßt werden kann und dieser kein Sensorsignal 17 an die Steuerung abgibt.

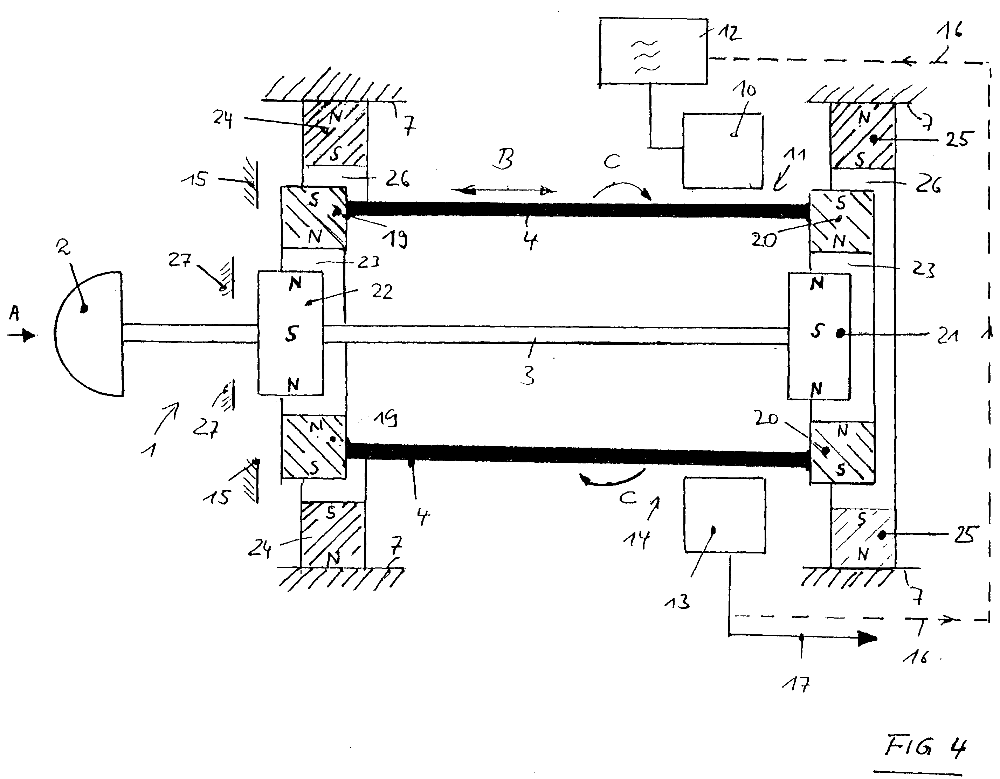

In den Figuren 3 bis 5 bezüglich der weiteren Ausführungsform gezeigte, mit Bauteilen nach den Figuren 1 und 2 übereinstimmende Bauteile sind der Einfachheit halber mit gleichen Bezugsziffern bezeichnet. Wie der Figur 3 für das nicht betätigte Stellteil 1 zu entnehmen ist, ist mit dem Ende 4a des Hohlzylinders 4 ein kreisringförmiger Permanentmagnet 19 und mit dem Ende 4b des Hohlzylinders 4 ein entsprechend ausgebildeter Permanentmagnet 20 verbunden. Die Permanentmagnete 19 und 20 weisen innen Nord-Polarität auf, außen Süd-Polarität. Mit dem dem Drucktaster 2 abgewandten Ende des Stößels 3 ist ein weiterer, kreisringförmiger Permanentmagnet 21 verbunden und, in einem Abstand, der dem der Permanentmagneten 19 und 20 entspricht, ist ein weiterer kreisringförmiger Permanentmagnet 22 mit dem Stößel 3 verbunden. Der Stößel 3 durchsetzt dabei kraftschlüssig die Ringöffnung der Permanentmagneten 21 und 22. Die Permanentmagnete 21 und 22 weisen außen Nord-Polarität und innen Süd-Polarität auf, zwischen diesen inneren, dem Stellteil 1 zugeordneten Magneten 21 und 22 und den dem Hohlzylinder 4 zugeordneten mittleren Magneten 20 und 19 sind Arbeitsspalte 23 gebildet. In entsprechendem Abstand wie die Magneten 19 und 20 sind zwei äußere, kreisringförmige Permanentmagnete 24 und 25 im Bereich der Gehäusewandung 7 mit dem Gehäuse des Befehlsgerätes verbunden. Die Permanentmagnete 24 und 25 weisen außen Nord-Polarität, innen Süd-Polarität auf. Zwischen den äußeren Magneten 24 und 25 und den mittleren Magneten 19 und 20 sind Arbeitsspalte 26 gebildet. Während die äußeren Magnete 24 und 25 aufgrund deren Verbindung mit dem Gehäuse stationär sind, ergibt sich eine stationäre Anlage des mittleren Magneten 19 entgegen der Betätigungsrichtung A des Stellteiles 1 am kreisringförmigen Anschlag 15 und des inneren Magneten 22 entgegen der Betätigungsrichtung A an einem weiteren, inneren, kreisringförmigen Anschlag 27. Die Anschläge 15 und 27 sind dabei so positioniert, daß bei nicht betätigtem Stellteil 1 die mittleren Magnete 19 und 20 bezüglich der jeweils zugeordneten äußeren Magnete 24 und 25 entgegen der Betätigungsrichtung des Stellteiles 1 versetzt sind und entsprechend die inneren Magnete 22 und 21 bezüglich der mittleren Magnete 19 und 20, wobei sich die Magnete 22 und 19, 19 und 24, 21 und 20, bzw. 20 und 25 aber überlappen. Aufgrund der gleichnamigen Polarität der jeweils gegenüberliegenden Magnete, haben diese das Bestreben sich abzustoßen, womit sich der mittlere Magnet 19 am Anschlag 15 und der innere Magnet 20 am Anschlag 27 anlegt. Wegen des sich zwischen den Magneten einstellenden Magnetfeldes wird der indirekt am Anschlag 15 anliegende Hohlzylinder 4 ansonsten zwischen dem Stellteil 1 und dem Gehäuse frei getragen.

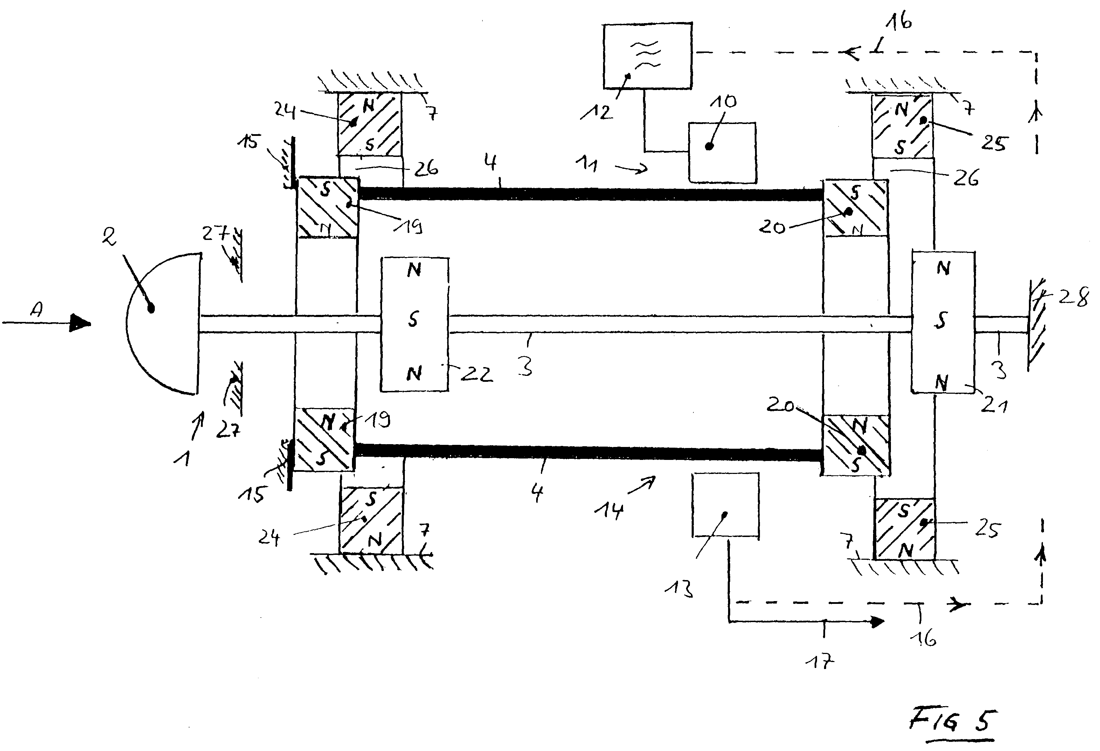

Beim Betätigen des Drucktasters 1 und damit bei einer entsprechenden Verschiebung der mit dem Stößel 3 verbundenen Magnete 21 und 22 vom Anschlag 27 weg - wie in Figur 4 verdeutlicht -, verschieben diese aufgrund des magnetischen Kraftfeldes die mittleren Magnete 19 und 20 entgegen der abstoßenden Kraft der äußeren Magnete 24 und 25 weiter in diese hinein, wobei der mittlere Magnet 19 außer Eingriff mit dem Anschlag 15 gelangt. Die hierdurch bedingte Verschiebung des Hohlzylinders 4 wird wiederum vom Sensor 14 erfaßt, der über das Sensorsignal 16 den Antrieb 11 aktiviert, die mittels des Antriebes 11 erzeugte Bewegung des Hohlzylinders 4 wird wie beschrieben vom Sensor 14 erkannt und als Sensorsignal 17 an das Steuersystem weitergeleitet. Wird der Drucktaster 2 losgelassen, legen sich die Magnete 19 und 22 wegen der abstoßenden Wirkung zwischen den äußeren, mittleren und inneren Magneten wieder an die Anschläge 15 und 27 an, die hierdurch bedingte Blockierung des Hohlzylinders 4 führt dazu, daß kein Ausgangssignal mehr vom Sensor 14 an das Steuersystem abgegeben wird. Grundsätzlich besteht bei der in den Figuren 3 und 4 gezeigten Ausbildung des Befehlsgerätes unter Verwendung von Magneten die Möglichkeit, nach Aufheben der Blockierung des Hohlzylinders 4 unterschiedliche Bewegungen über den Antrieb 11 in den Hohlzylinder 4 einzuleiten. Die Doppelpfeile B verdeutlichen beispielsweise eine translatorisch oszillierende Bewegung entsprechend dem Ausführungsbeispiel mit den Federn, der einfache Pfeil C zeigt, daß auch eine über den Antrieb 11 eingeleitete nicht oszillierende, rein rotatorische Bewegung des Hohlkörpers 4 zusammen mit den mittleren Magneten 19 und 20 denkbar ist. Grundsätzlich wäre es - wie bei der Ausbildung mit den Federn - auch möglich, eine rotatorisch oszillierende Bewegung auf den Hohlzylinder 4 aufzubringen.

Figur 5 zeigt ein Befehlsgerät mit dem drei Schaltzustände darstellbar sind. Der erste Schaltzustand bei nicht betätigtem Drucktaster 2 ergibt sich aus der Darstellung der Figur 3, der zweite Schaltzustand bei normal betätigtem Drucktaster 2, bei dem der Hohlzylinder 4 freikommt, ergibt sich aus der Darstellung der Figur 4, während die Darstellung der Figur 5 eine Not-Aus-Stellung zeigt, bei der das Stellteil 1 weiter gegen einen Anschlag 28 in Betätigungsrichtung A gedrückt ist. Beim Bewegen des Stellteiles 1 von der Position gemäß Figur 4 in die gemäß Figur 5, ergeben sich zwischen den inneren, mittleren und äußeren Magneten solche magnetischen Kraftverhältnisse, daß die axiale Kraft der äußeren Magnete 24 und 25 auf die mittleren Magnete 19 und 20 größer ist als die der mittleren Magnete 19 und 20 auf die inneren Magnete 22 und 21, wodurch die inneren Magnete 22 und 21 bezüglich der mittleren Magnete 19 und 20 "Überschnappen", so daß die abstoßende Wirkung zwischen den inneren Magneten 22, 21 und den mittleren Magneten 19, 20 dazu führt, daß sich die mittleren Magnete 19, 20 und der Hohlzylinder 4 entgegen der Betätigungsrichtung gegen den dem Magnet 19 zugeordneten Anschlag 15 bewegen, womit der Hohlzylinder 4 blockiert wird, wobei jedoch das Stellteil 1 in Anlage am Anschlag 28 verbleibt. Die in Figur 3 gezeigte Ausgangsstellung kann dann nur durch ein aktives Herausziehen des Drucktasters 2 gegen den dem Magneten 22 zugeordneten Anschlag 27 wieder erreicht werden.

Bei einer denkbaren Variante mit Druckfedern sind diese entsprechend der Ausbildung der Magnete gemäß der Variante nach den Figuren 3 bis 5 positioniert, das heißt sie sind in einer entsprechend schrägen Wirklinie angeordnet.

### Bezugszeichenliste

- 1: Stellteil
- 2: Drucktaster
- 3: Stößel
- 4: Hohlzylinder
- 4a: Ende
- 4b: Ende
- 5: Spiral-Zugfeder
- 6: Spiral-Zugfeder
- 7: Gehäusewandung
- 8: Spiral-Zugfeder
- 9: Spiral-Zugfeder
- 10: Elektromagnet
- 11: Antrieb
- 12: Oszillator
- 13: Elektromagnet
- 14: Sensor
- 15: Anschlag
- 16: Sensorsignal
- 17: Sensorsignal
- 18: Anschlag
- 19: Permanentmagnet
- 20: Permanentmagnet
- 21: Permanentmagnet
- 22: Permanentmagnet
- 23: Arbeitsspalt
- 24: Permanentmagnet
- 25: Permanentmagnet
- 26: Arbeitsspalt
- 27: Anschlag
- 28: Anschlag

## Patentansprüche

1. Befehlsgerät mit einem beweglichen Stellteil (1) zur Fortleitung eines in dieses durch dessen Betätigung (A) eingebrachten Eingangsbefehles an ein Steuersystem, wobei ein Antrieb (11) vorgesehen ist, mit dem ein Hilfskörper (4) in eine Bewegung versetzbar ist, wobei ein Sensor (14) die Bewegung des Hilfskörpers (4) erfaßt und diese als Ausgangssignal an das Steuersystem weiterleitet, und wobei, sobald die Bewegung des Hilfskörpers (4) beim Auftreten von Fehlern im Befehlsgerät blockiert wird, der Antrieb (11) nicht mehr in der Lage ist, den Hilfskörper (4) in Bewegung zu halten und dadurch das Ausgangssignal nicht mehr vom Sensor (14) weitergeleitet wird, **dadurch gekennzeichnet**, daß das Stellteil (1) bei Betätigung (A) den über federnde Elemente (5, 6, 8, 9) oder Magnete (22, 21, 19, 20, 24, 25) positionierten Hilfskörper (4) so in seiner Lage verändert, daß er von seiner Blockierung (15) freikommt, wobei die federnden Elemente (5, 6, 8, 9) oder Magnete (22, 21, 19, 20, 24, 25) derartig angeordnet sind, daß der Hilfskörper (4) wieder blockiert wird, wenn die Betätigung des Stellteils (1) beendet wird, womit der Antrieb (11) nicht mehr in der Lage ist, den Hilfskörper (4) in Bewegung zu halten, und dadurch das Ausgangssignal (17) nicht mehr vom Sensor (14) weitergeleitet wird.

2. Befehlsgerät nach Anspruch 1, **dadurch gekennzeichnet**, daß der Hilfskörper (4) mittels Federn (5, 6, 8, 9) zwischen dem Stellteil (1) und einem stationären Bauteil (7) des Befehlsgerätes aufgehängt ist.

3. Befehlsgerät nach Anspruch 2, **dadurch gekennzeichnet**, daß der Hilfskörper als Hohlzylinder (4) ausgebildet ist, den das Stellteil (1) in dessen Längsachse durchsetzt, wobei innere Federn (5, 6) im Bereich beider Hohlzylinderenden (4a, 4b) an diesem und dem Stellteil (1) angreifen, sowie äußere Federn (8, 9) im Bereich beider Hohlzylinderenden (4a, 4b) an diesem und dem stationären Bauteil (7) angreifen.

4. Befehlsgerät nach Anspruch 3, **dadurch gekennzeichnet**, daß die äußeren Federn (8, 9) bei nicht betätigtem Stellteil (1) den Hilfskörper (4) gegen die Blockierung (15) vorspannen.

5. Befehlsgerät nach einem der Ansprüche 1 bis 4, **dadurch gekennzeichnet**, daß die Blockierung als stationärer Anschlag (15) ausgebildet ist.

6. Befehlsgerät nach Anspruch 5, **dadurch gekennzeichnet**, daß der Anschlag (15) auf dem dem Betätigungspunkt (2) des Stellteils (1) zugewandten Ende (4a) des Hilfskörpers (4) in dessen Bewegungsweg ragt.

7. Befehlsgerät nach einem der Ansprüche 2 bis 6, **dadurch gekennzeichnet**, daß die Federn als Zugfedern, insbesondere Spiral-Zugfedern (5, 6, 8, 9) ausgebildet sind.

8. Befehlsgerät nach einem der Ansprüche 2 bis 6, **dadurch gekennzeichnet**, daß die Federn (5, 6, 8, 9) als Druckfedern, insbesondere Spiral-Druckfedern ausgebildet sind.

9. Befehlsgerät nach Anspruch 1, **dadurch gekennzeichnet**, daß der Hilfskörper (4) mittels an diesem, am Stellteil (1) und an einem stationären Bauteil (7) des Befehlsgerätes angeordneter Magnete (22, 21, 19, 20, 24, 25) zwischen dem Stellteil (1) und dem stationären Bauteil (7) positioniert ist.

10. Befehlsgerät nach Anspruch 9, **dadurch gekennzeichnet**, daß der Hilfskörper als Hohlzylinder (4) ausgebildet ist, den das Stellteil (1) in dessen Längsachse durchsetzt, wobei innere Magnete (22, 21) mit dem Stellteil (1), mittlere Magnete (19, 20) mit dem Hohlzylinder (4) und äußere Magnete (24, 25) mit dem stationären Bauteil (7) verbunden sind, wobei ferner die inneren und mittleren bzw. mittleren und äußeren Magnete in den einander zugewandten Wirkbereichen gleiche Polarität aufweisen und bei nicht betätigtem Stellteil (1) dieses in derselben Wirkrichtung wie der Hohlzylinder (4) blockiert ist.

11. Befehlsgerät nach Anspruch 10, **dadurch gekennzeichnet**, daß die mittleren Magnete (19, 20) im Bereich der Hohlzylinderenden (4a, 4b) angeordnet sind, in gleichem Abstand wie die mittleren Magnete (19, 20) die inneren Magnete (22, 21) bzw. die äußeren Magnete (24, 25) zueinander beabstandet angeordnet sind und die als stationäre Anschläge (27, 15) ausgebildeten Blockierungen für das Stellteil (1) und den Hohlzylinder (4), sowie ferner die äußeren Magnete (24, 25) so positioniert sind, daß bei Anlage an den Anschlägen (27, 15) die dem jeweiligen Ende des Hohlzylinders (4) zugeordneten Magnete (22, 19, 24; 21, 20 25) vom inneren Magnet zum äußeren Magnet und vom dem inneren Magneten (22) zugeordneten Anschlag (27) weggerichtet zueinander versetzt angeordnet sind.

12. Befehlsgerät nach einem der Ansprüche 1 bis 11, **dadurch gekennzeichnet**, daß die Stellbewegung des Stellteils (1) in Betätigungsrichtung (A) durch einen Anschlag (18, 28) begrenzt ist.

13. Befehlsgerät nach einem der Ansprüche 1 bis 12, **dadurch gekennzeichnet**, daß der Antrieb (11) als magnetisches System ausgebildet ist, das bevorzugt aus einem Elektromagneten (10) und dem Hilfskörper (4) besteht.

14. Befehlsgerät nach Anspruch 13, **dadurch gekennzeichnet**, daß der Hilfskörper (4) mittels des Antriebs (11) translatorisch oszillierend, rotatorisch oszillierend oder rotatorisch nicht oszillierend bewegbar ist.

15. Befehlsgerät nach einem der Ansprüche 1 bis 14, **dadurch gekennzeichnet**, daß der Sensor (14) als elektromagnetisches System ausgebildet ist, das bevorzugt aus einem Elektromagneten (13) und dem Hilfskörper (4) besteht.

## Claims

1. A control device having a movable operating element (1) for transmitting an input command, which is introduced into the control device by the actuation (A) of the operating element, to a control system, wherein a drive (11) is provided by means of which an auxiliary body (4) can be set in motion, wherein a sensor (14) detects the motion of the auxiliary body (4) and transmits this as an output signal to the control system, and wherein, as soon as the motion of the auxiliary body (4) is obstructed when malfunctions occur in the operating element, the drive (11) is no longer capable of keeping the auxiliary body (4) in motion and the output signal is thereby no longer transmitted from the sensor (14), **characterised in that** on actuation (A), the operating element (1) alters the position of the auxiliary body (4), which is positioned via spring elements (5, 6, 8, 9) or magnets (22, 21, 19, 20, 24, 25), so that it is released from its obstruction (15), wherein the spring elements (5, 6, 8, 9) or magnets (22, 21, 19, 20, 24, 25) are disposed in such a way that the auxiliary body (4) is obstructed again when the actuation of the operating element (1) is ended, whereby the drive (11) is no longer capable of keeping the auxiliary body (4) in motion, and the output signal (17) is thereby no longer transmitted by the sensor (14).

2. A control device according to claim 1, **characterised in that** the auxiliary body (4) is suspended by means of springs (5, 6, 8, 9) between the operating element (1) and a fixed component (7) of the control device.

3. A control device according to claim 2, **characterised in that** the auxiliary body is constructed as a hollow cylinder (4) through which, on the longitudinal axis thereof, the operating element (1) passes, wherein internal springs (5, 6) in the region of both hollow cylinder ends (4a, 4b) act on the hollow cylinder and on the operating element (1), and external springs (8, 9) in the region of both hollow cylinder ends (4a, 4b) act on the hollow cylinder and on the fixed component (7).

4. A control device according to claim 3, **characterised in that** when the operating element (1) is not actuated the external springs (8, 9) bias the auxiliary body (4) towards the obstruction (15).

5. A control device according to any one of claims 1 to 4, **characterised in that** the obstruction is constructed as a fixed stop (15).

6. A control device according to claim 5, **characterised in that** the stop (15) protrudes into the path of motion of the auxiliary body (4) at the end (4a) thereof which faces the actuating point (2) of the operating element (1).

7. A control element according to any one of claims 2 to 6, **characterised in that** the springs are constructed as tension springs, particularly as flat spiral tension springs (5, 6, 8, 9).

8. A control device according to any one of claims 2 to 6, **characterised in that** the springs (5, 6, 8, 9) are constructed as pressure springs, particularly as flat spiral pressure springs.

9. A control device according to claim 1, **characterised in that** the auxiliary body (4) is positioned between the operating element (1) and the fixed component (7) by means of magnets (22, 21, 19, 20, 24, 25) disposed on the auxiliary body, on the operating element (1) and on a fixed component (7) of the control device.

10. A control device according to claim 9, **characterised in that** the auxiliary body is constructed as a hollow cylinder (4) through which, on the longitudinal axis thereof, the operating element (1) passes, wherein inner magnets (22, 21) are attached to the operating element (1), middle magnets (19, 20) are attached to the hollow cylinder (4) and outer magnets (24, 25) are attached to the fixed component (7), wherein in addition the inner and middle and middle and outer magnets, respectively, have the same polarity in their mutually facing active regions, and when the operating element (1) is not actuated it is obstructed in the same direction of action as the hollow cylinder (4).

11. A control device according to claim 10, **characterised in that** the middle magnets (19, 20) are disposed in the region of the hollow cylinder ends (4a, 4b), the inner magnets (22, 21) and the outer magnets (24, 25), respectively, are disposed spaced apart from each other at the same spacing as the middle magnets (19, 20), and the obstructions, which are constructed as fixed stops (27, 15), for the operating element (1) and the hollow cylinder (4), and the outer magnets (24, 25) in addition, are positioned so that on contacting the stops (27, 15) the magnets (22, 19, 24; 21, 20, 25) associated with the respective end of the hollow cylinder (4) are disposed displaced in relation to each other directed away from the inner magnet towards the outer magnet and away from the stop (27) associated with the inner magnet (22).

12. A control device according to any one of claims 1 to 11, **characterised in that** the operating motion of the operating element (1) in the direction of actuation (A) is limited by a stop (18, 28).

13. A control device according to any one of claims 1 to 12, **characterised in that** the drive (11) is constructed as a magnetic system which preferably consists of an electromagnet (10) and the auxiliary body (4).

14. A control device according to claim 13, **characterised in that** the auxiliary body (4) can be moved by means of the drive (11) so that it oscillates in translational motion, oscillates in rotation, or rotates without oscillation.

15. A control device according to any one of claims 1 to 14, **characterised in that** the sensor (14) is constructed as an electromagnetic system which preferably consists of an electromagnet (13) and the auxiliary body (4).

## Revendications

1. Appareil de commande comprenant :
- un organe de commande mobile (1) servant à transmettre à un système de commande un ordre d'entrée généré dans celui-ci par son actionnement (A),
- un entraînement (11) est prévu pouvant déplacer un corps auxiliaire (4) dans un déplacement saisi par un détecteur (14) qui le transmet sous forme de signal de sortie au système de commande, appareil dans lequel, dès que le déplacement du corps auxiliaire (4) se trouve bloqué par l'arrivée d'un défaut dans l'appareil, l'entraînement (11) n'est plus en mesure de maintenir en mouvement le corps auxiliaire (4) et en conséquence le signal de sortie (14) du détecteur n'est plus transmis,
caractérisé en ce que
l'organe de commande (1), lors de son actionnement (A), déplace le corps auxiliaire (4) dont la position est assurée par des éléments élastiques (5, 6, 8, 9) ou magnétiques (22, 21, 19, 20, 24, 25), de manière à le libérer de son blocage (15), les éléments élastiques (5, 6, 8, 9) et/ou magnétiques (22, 21, 19, 20, 24, 25) étant disposés de manière que le corps auxiliaire (4) se trouve à nouveau bloqué lorsque l'actionnement de l'organe de commande (1) cesse, l'entraînement (11) n'étant alors plus en mesure de maintenir le corps auxiliaire (4) en déplacement et corrélativement le signal de sortie (17) n'étant plus transmis par le détecteur (14).

2. Appareil de commande selon la revendication 1,
caractérisé en ce que
le corps auxiliaire (4) peut être suspendu par des ressorts (5, 6, 8, 9) entre l'organe de commande (1) et un élément stationnaire (7) de l'appareil.

3. Appareil de commande selon la revendication 2,
caractérisé en ce que
le corps auxiliaire est un cylindre creux (4) traversé selon son axe longitudinal par l'organe de commande (1), les ressorts internes (5, 6) étant en prise avec lui dans la zone des deux extrémités (4a, 4b) du cylindre creux et avec l'organe de commande (1), tandis que les ressorts externes (8, 9) sont en prise dans la zone des deux extrémités du cylindre (4a, 4b) avec lui et avec l'élément stationnaire (7).

4. Appareil de commande selon la revendication 3,
caractérisé en ce que
les ressorts externes (8, 9), lorsque l'organe de commande (1) n'est pas actionné, appliquent avec tension le corps auxiliaire (4) sur le blocage (15).

5. Appareil de commande selon l'une des revendications 1 à 4,
caractérisé en ce que
le blocage est constitué par une butée stationnaire (15).

6. Appareil de commande selon la revendication 5,
caractérisé en ce que
la butée (15) dépasse par rapport à l'extrémité (4a) du corps auxiliaire (4) faisant face au point d'actionnement (2) de l'organe de commande (1), lorsque le corps auxiliaire se déplace.

7. Appareil de commande selon une des revendications 2 à 6,
caractérisé en ce que
les ressorts sont des ressorts de traction, en particulier des ressorts en spirale (5, 6, 8, 9).

8. Appareil de commande selon une des revendications 2 à 6,
caractérisé en ce que
les ressorts sont des ressorts de compression, en particulier des ressorts en spirale (5, 6, 8, 9).

9. Appareil de commande selon la revendication 1,
caractérisé en ce que
le corps auxiliaire (4) est positionné entre l'organe de commande(1) et l'élément stationnaire (7) de l'appareil par des aimants (22, 21, 19, 20, 24, 25) montés sur le corps auxiliaire, sur l'organe de commande et sur l'élément stationnaire (7).

10. Appareil de commande selon la revendication 9,
caractérisé en ce que
le corps auxiliaire est un cylindre creux (4) traversé selon son axe longitudinal par l'organe de commande (1), les aimants internes (22, 21) sont reliés à l'organe de commande (1), les aimants médians (19, 20) au cylindre creux (4), les aimants externes (24, 25) au composant stationnaire (7), les aimants internes et médians ou médians et externes présentant la même polarité dans leurs zones d'action en regard et l'organe de commande (1) lorsqu'il n'est pas actionné, étant bloqué dans la même direction d'action que le cylindre creux (4).

11. Appareil de commande selon la revendication 10,
caractérisé en ce que
les aimants médians (19, 20) sont montés près des extrémités (4a, 4b) du cylindre creux, tandis que les aimants internes (22, 21) ainsi que les aimants externes (24, 25) sont espacés entre eux comme les aimants médians (19, 20) et que les blocages de l'organe de commande (1) et du cylindre creux (4), constitués par les butées stationnaires (27, 15), ainsi que les aimants externes (24, 25) sont positionnés de manière que, lorsqu'il y a appui sur les butées (27, 15) les aimants (22, 19, 24 ; 21, 20, 25) associés respectivement aux extrémités du cylindre creux (4) ont des positions décalées les unes par rapport aux autres, selon la direction de déplacement, de l'aimant interne vers l'aimant externe et à partir de la butée (27) associée à l'aimant interne (22).

12. Appareil de commande selon une des revendications 1 à 11,
caractérisé en ce que
le mouvement de l'organe de commande (1) selon la direction d'actionnement (A) est limité par une butée (18, 28).

13. Appareil de commande selon une des revendications 1 à 12,
caractérisé en ce que
l'entraînement (11) est un système magnétique, constitué de préférence par un électroaimant (10) et par le corps auxiliaire (4).

14. Appareil de commande selon la revendication 13,
caractérisé en ce que
le corps auxiliaire (4) peut être déplacé par l'entraînement (11) en translation avec oscillation, en rotation avec ou sans oscillation.

15. Appareil de commande selon une des revendications 1 à 14,
caractérisé en ce que
le détecteur (14) est un système électromagnétique constitué de préférence par un électroaimant (13) et par le corps auxiliaire (4).
